# EUROPEAN PATENT APPLICATION

(11) **EP 1 811 556 A1**
(43) Date of publication of application: **25.07.2007**
(21) Application number: 05788208.6
(22) Date of filing: 29.09.2005
(51) Int. Cl.: H01L 21/60, C22C 5/02

(54) **WIRE BUMP MATERIAL**

(30) Priority: 30.09.2004 JP 2004287599
(71) Applicant: TANAKA DENSHI KOGYO KABUSHIKI KAISHA, Tokyo 100-6422 (JP)
(72) Inventor: MIKAMI, Michitaka, Tanaka Denshi Kogyo K.K., Kanzaki-gun Saga 842-0031 (JP); ARIKAWA, Takatoshi, Tanaka Denshi Kogyo K.K., Kanzaki-gun Saga 842-0031 (JP)
(74) Representative: Röthinger, Rainer
(86) International application number: PCT/JP2005/018024
(87) International publication number: WO 2006/035905

(57) **Abstract**

The present invention was held in order to resolve problems on above-mentioned conventional wire bumping material.
This invention has the following purposes;
(1) approximating Au-Ag alloy bumping balls to bond Al pads to ideal sphere shape
(2) increasing assurance of Au-Ag alloy bump bonding to Al pads
(3) shortening tail length of Au-Ag alloy bump
(4) improving anti-Au consumption into solder
(5) decreasing contamination of capillary tip by bump wire and hole around tip

Means for resolution

Au-Ag alloy for wire bumping comprising wherein Au, which purity is more than 99.99 mass %, comprising Au matrix and a particle of additive elements, consisting of 1 to 40 mass % Ag, which purity is more than 99.99 mass %.

## Description

This application is based on Japanese Patent Application No. 2004-287599, filed on Nov. 30, 2004, the entire contents of which are incorporated herein by reference.

### FIELD OF THE INVENTION

The present invention relates to metal alloy or material for wire bumping to form bump, using wire bonding technique.

### STATE OF THE ART

Conventionally, it is known that method of forming metallic bump, using wire bonding method, bonding with electrodes on the IC chips or transistors and leads of TAB (Tape Automated Bonding), lead frames and/or outer terminals on ceramic substrates. This wire bumping method has an advantage to manufacture high density packages and thin type packages, because of direct bonding to electrode pads on IC chips and outer terminals through bump and lower height of bonded part comparing with a case of using wire-bonding. For example, there are flip chip method, forming bumps on electrodes of IC chip in advance, bonding with these bumps against molten solder on conductive circuit of printed circuit substrate, and also film carrier method, molten bonding with Cu tape plated solder.
High purity Au, under constraint of which purity should be more than 99.99 mass %, has been used for wire bumping alloy so far. Whereas in the case of using high purity Au, after ultrasonic bonding to IC chip forming balls on ultra fine wire in advance, tearing off a part of the wire held with a clamp, problem occur that tails, which is principal cause of incorrect contact, remained on the side of bumps, namely on remained balls of IC chips. Hence study on shortening the length of tails had been done such as Au matrix alloy consisting of 0.5 to 10 weight % Pd(Japanese Patent No. 2737953) and Au matrix alloy consisting of 0.003 to 5 weight % Pd(Japanese Patent Application Laid-Open Publication No. 9-321076), and Au matrix alloy consisting of 0.001 to 5 weight % Pt, Pd and/or Ru (Japanese Patent Application Laid-Open Publication No. 10-287936). However, genus of platinum, like Pd, etc. is very expensive, moreover it is necessary specific facilities and more expensive comparing with Au, conventionally had been used as purity of 99.9 % Au, which contained much impurities. Moreover, increasing additives of genus of platinum, inside of capillary is contaminated, and this contamination make non-spherical ball attached to wire, and balls become harder and Si chip is broken under Al pad, for such problems, practically, it had been used Au-1% Pd alloy.
Though this Au-1% Pd alloy has advantage such as effect of repression of Au-Al compound growth between Al pad and Au-Pd alloy bump, at the moment of tearing off, still long tails emerge occasionally. Moreover, recently soldering process tend to operate at higher temperature such as 200 °C to 300 °C, especially in the case of Pb-free Sn matrix soldering, higher temperature operation is noticeable. When operating temperature become higher temperature, phenomena of solder consumption occur, namely Au rapidly melt into solder, it is forced to operate soldering under strict temperature control. Though Au-5% Pd alloy has been studied, ball bonding in the air, because of forming hard balls, problem of grater chip damage against Al pad, and problem of big fluctuation of Pd market price, said capillary contamination and length of tails, it had not been in practical use.

### DISCLOSURE OF INVENTION

### ISSUES TO BE SOLVED BY THE PRESENT INVENTION

The present invention has been done to solve above-mentioned problems of conventional Au alloy for wire bumping.
The present invention has the following purposes;
(1) approximating Au-Ag alloy bumping balls to bond Al pads to ideal sphere shape
(2) increasing assurance of Au-Ag alloy bump bonding to Al pads
(3) shortening tail length of Au-Ag alloy bump
(4) improving anti-Au consumption into solder
(5) decreasing contamination of capillary tip by bump wire and hole around tip

According to the present invention, there are provided following wire bumping materials;
(1) Au-Ag alloy for wire bumping comprising featured wherein Au, which purity is more than 99.99 mass %, comprising Au matrix and 1 to 40 mass % of Ag, which purity is more than 99.99 mass %.
(2) Au-Ag alloy for wire bumping according to above-mentioned (1), featured wherein said a particle of additive elements, consisting of 5 to 50 mass ppm of Ca, 1 to 20 mass ppm of Be and/or 5 to 90 mass ppm of rare-earth elements.
(3) Au-Ag alloy for wire bumping according to above-mentioned (1), featured wherein said a particle of additive elements, consisting of 10 to 90 mass ppm of one element, at least, selected from a group consisting ofGe, Mg, Sr, Bi, Zn, Si, Ga, Sn, Sb, Li, and alloy there of.
(4) Au-Ag alloy for wire bumping according to above-mentioned (1), featured wherein said a particle of additive elements, consisting of 5 to 50 mass ppm of Ca, 1 to 20 mass ppm of Be and/or 10 to 90 mass ppm of at least one element among rare-earth elements selected from a group consisting of Ge, Mg, Sr, Bi, Zn, Si and Ga, wherein said in the case of single element; B or Li, 0.5 to 40 mass ppm.
(5) Au-Ag alloy for wire bumping according to above-mentioned (1), (2), (3) and(4), featured wherein said Au matrix consisting of 5 to 25 mass % of Ag.
(6) Au-Ag alloy for wire bumping according to above-mentioned (2) or (4), featured wherein said a particle of additive rare-earth elements, consisting ofY, La, Ce, Eu, Nd, Gd, Sm, and alloy there of..
(7) Au-Ag alloy for wire bumping according to above-mentioned (1) to (6), featured wherein said bonding to Pb matrix solder or Sn matrix solder.
(8) Au-Ag alloy for wire bumping according to above-mentioned (1) to (6), featured wherein said flip chip bonding to Pb-free Sn matrix solder.
(9) Au-Ag alloy for wire bumping according to above-mentioned (1) to (6), featured wherein said flip chip bonding to Pb-free Sn matrix solder, which has 170 °C to 260 °C melting point.

### EFFECTS OF THE PRESENT INVENTION

Effect of approximating Au-Ag alloy soft bumping ball shape to bond Al pads to ideal sphere shape is accounted hereinafter.
Using Au-Ag alloy of the present invention, because a spherical soft ball is formed during ball forming process in the air, Al pad on chip has no damage. Moreover, Ca. Be or rare-earth elements, or a particle of group of elements such as Ge, Mg, Sr, Bi, Zn, Si, Ga, Sn, Sb, B or Li are oxidized during bonding to Al pad, abnormal shape of balls is not generated. Consequently it is absolutely able to ball-bond for bump-wire with set circular area at appropriate position even in the case of smaller pad area.
Next effect of increasing assurance of Au-Ag alloy bump bonding to Al pad is accounted hereinafter. In the case of high purity Au-Ag alloy matrix of the present invention, since at pure Al or Al alloy pads formation of inter-metallic compounds between Al and Au will be delayed, Au₄Al does not generate among these inter-metallic compounds, so assurance of bonding to Al pads increase. It is available that Al pads are pure Al or Al principal content alloy, for instance, 80% Al-Cu alloy etc.. Moreover, in the case of plastic mold, because inter-metallic compounds do not generate, it is able to prevent corrosion attacked by halogen from contained plastic.
Next effect of shortening tail length of Au-Ag alloy bump is accounted hereinafter.
In the case of high purity Au-Ag alloy matrix of the present invention, a particle of additive elements works effectively than that of pure Au matrix, even if in the case of maximum content of a particle of additive elements and impurity elements only 100 ppm (where exception Ag), dispersion of bump tails are smaller. Since the smaller dispersion of bump tails, the more homogenous bumps is able to be manufactured, there are greater deference of neck strength, and effect of stability for many number of bumps.
Next effect of improving anti-Au consumption into solder is accounted hereinafter.
In the case of high purity Au-Ag alloy matrix of the present invention, because of improving anti-Au consumption into solder, Au-Ag alloy bump does not disappear into solder during flip chip bonding. For this reason, range of selection of solder is expanded, through high temperature reflow after soldering, flip chip bond, which has stable bonding strength is attained. Since range of temperature is broader for usable specific solder, work management of soldering is loosened. Moreover, as it is able to manufacture homogenous bumps as small as dispersion of bump tails, it is able to disappear selectively only part of tails of Au-Ag alloy bump, therefore distribution of tail length become more and more small. Especially in the case of 5 to 25 mass % of Ag in the Au-Ag alloy matrix, as improving anti-Au consumption into solder at high temperature, stable flip chip structure is obtained. Moreover since decreasing consumption such as elements of Au etc. into solder, fragile compounds do not grow in solder.

### DESCRIPTION OF THE MOST PREFERRED EMBODIMENT

Wire bump material of the present invention is Au-Ag alloy and a partial of additive elements. Content of Ag is 1 to 40 mass %, preferably, 5 to 25 mass %. Purity of Ag is more than 99.99 mass %.

In the first preferred embodiment of the present invention, Ca, Be and/or rare-earth elements(so called as Group A elements) are used. These elements are available to select single or combination of more than 2 elements. Content of these elements, in the case of Ca, is 5 to 50 mass ppm, and more preferable 8 to 35 mass ppm. In the case of Be, it is 1 to 20 mass ppm, more preferable 3 to 18 mass ppm. In the case of rare-earth elements, it is 5 to 90 mass ppm. In the case of plural use of these elements, the total amount of content should be less than 90 mass ppm, more preferable less than 50 mass ppm. As rare-earth elements are selected from Y, La, Ce, Eu, Nd, Gd and Sm, at least one element should be selected preferably.

In other preferred embodiment of the present invention, a particle of additive elements are selected from Ge, Mg, Sr, Bi, Zn, Si, Ga, Sn, Sb, B and Li, at least one element should be selected preferably. Content of these elements(so called as Group B elements) is 10 to 90 mass ppm. Especially preferable elements are Ge, Bi, Si, Sn, Sb, B and/or Li.
In the case of using Ge, Bi, Si, Sn and/or Sb(so called as Group B¹), content is 10 to 90 mass ppm, more preferable 15 to 60 mass ppm.
In other preferred embodiment of the present invention, combination of elements of Group A and Group B is used. In this case, content of Group A, in the case of said Ca, content is 5 to 50 mass ppm, more preferable 8 to 35 mass ppm, in the case of Be, content is 1 to 20 mass ppm, more preferable 3 to 18 mass ppm, in the case of rare-earth elements, content is 3 to 90 mass ppm. In the case of plural elements of Group A, the total amount of content should be less than 90 mass ppm, more preferable less than 50 mass ppm.
In the case of using Group B, said elements are only B and/or Li(so called as Group B²), content is 0.5 to 40 mass ppm, more preferable 0.5 to 15 mass ppm. In the case of plural elements of Group B², the total amount of content should be less than 15 mass ppm preferably.
In the case of consisting of Group A, Group B¹ and Group B², the content of said Group B² is 0.5 to 40 mass ppm, more preferable 0.5 to 15 mass ppm. Moreover, in this case, the total amount of content should be less than 90 mass ppm, preferably less than 50 mass ppm.

Effect of approximating Au-Ag alloy bumping balls to bond Al pads to ideal sphere shape is accounted hereinafter..
In general, it is easy to obtain ideal spherical balls in the case of Au alloy, which purity is higher 99.99 mass % with a partial of additive elements, also in the case of Au-several % Pd alloy in the air.
In the case of Au-Ag alloy, Ag is apt to capture oxygen from high temperature air, increasing content of Ag, a partial of additive elements is oxidized and is apt to form abnormal shape of balls, then during bonding it cause of damage into Al pads. Hence the upper limit of content of Ag should be less than 40 mass %, so circular bonds are obtained on the Al pads through ball-bonding in the air. Moreover, using purity of 99.99 mass % of Ag, though concentrated Ag into Au, soft balls are obtainable, and adding a partial additives in order to obtain true sphere, such as Ca is 5 to 50 mass ppm, Be is 1 to 20 mass ppm and/or rare-earth elements are 5 to 90 mass ppm, or at least one element from Ge, Mg, Sr, Bi, Zn, Si, Ga, Sn, Sb, B or Li, the total amount of content is 10 to 90 mass ppm(where in the case of single use of B and Li, 10 to 90 mass ppm).
Former said a partial of additive elements(Group A) has grater roll against Au-Ag matrix than that of latter Group B elements. Hereinafter, the reason of set 5 to 50 mass ppm of Ca among the former said a partial additive elements it become to be difficult to approximate shape of balls to true sphere under condition of less than 5 mass ppm, on the contrary, shape of balls is apt to deform under condition of excess 50 mass ppm. The upper limit and lower limit for Be and rare-earth elements are from same reason. Especially Y, La, Ce, Eu and Nd among rare-earth elements at the range of content from 10 to 90 mass ppm are apt to obtain circular bumps. On the other hand, the latter Group of elements consist of eutectic alloy with Au has more feeble effect to form spheres in the air than that of former elements to Au-Ag matrix, when the total amount of content is 10 to 90 mass ppm selected at least one element, from Ge, Mg, Sr, Bi, Zn, Si, Ga, Sn, Sb, B and Li(where in the case of single use of B and Li, 0.5 to 40 mass ppm), Au-Ag alloy bumps are formed with no problem in practical use corresponding to small pitch, moreover to meet to purity of 99.99 mass % of Au alloy(where except content of Ag) Less than 10 mass ppm of these elements(in the case of single use of B and Li, 0.5 mass ppm), it is not able to obtain preferable true circular shape.
Moreover, exceed 90 mass ppm does not meet to purity 99.99 mass % Au(where without Ag). so inconvenience of display as "High purity Au" will occur and in the case of heterogeneous alloy, the Au-Ag alloy becomes to be difficult to form and approximate the balls to sphere shape on Al pads. Especially in the case of single use of B and Li, exceed of 40 mass ppm is apt to difficult to form ball to sphere shape.
Purity of 99.99 mass % of Au alloy contains these former and latter group of a partial of additive elements and inevitable impurity elements(where except Ag), which is less than 100 mass ppm in maximum, so it is always able to form stable circular shape.

Effect of increasing assurance of Au-Ag alloy bump bonding to A1 pads is accounted hereinafter.
It is known that for Au-Ag alloy matrix comparing with Pure Au matrix and Au-Pd alloy matrix, there is delay to generate inter-metallic compound between Al and Au at Al pad, and there is no Au₄Al in this inter-metallic compound. It is also found that Au₄Al in Pure Au matrix and Au-Pd alloy matrix is not generated, a partial of additive elements of the present invention for bump in Au-Ag alloy matrix remain in matrix and has no reaction with Al. Thus Au-Ag alloy matrix has a roll to delay of generating inter-metallic compounds comparing with Pure Au matrix and Au-Pd alloy matrix. Moreover, in the case of Au-Ag alloy matrix added a partial of additive elements above-mentioned, ideal sphere shape is obtained. Besides, in the case of a partial of additive elements contains only less than 100 mass ppm in maximum, as purity 99.99 mass % of Au-Ag alloy matrix(where without Ag) is maintain, so it is able to increase assurance of Au-Ag alloy bump bonding to Al pads. Incidentally it is found that there is no chip damage to Al pad and a partial of additive elements disperse finely by conventional dissolution and casting process, if total content is 0.009 to 0.3 mass ppm at least more than one element of Ge, Mg, Sr, Bi, Zn, Si, Ga, Sn, Sb and Li.

Effect of shortening tail length of Au-Ag alloy bump is accounted hereinafter.
Inventors of the present invention considered that dispersion of tail length of bump is difference between strength of bump wire itself and strength of heat affected part(so called "neck strength difference"). In the case of less than 1 mass % Ag in the Au-Ag alloy matrix, Au-Ag alloy matrix itself becomes rather soft, yet adding a set of a partial of additive elements as same as Pure Au matrix. In the case of bump wire becoming soft, strength of wire become weak and neck strength difference become small. Consequently, torn position of bump wire is dispersing, and tail length is apt to disperse. Then using a set of ratio of Au-Ag alloy matrix, neck strength difference is able to be grater than that of Pure Au matrix and Au-Pd alloy matrix. Moreover if not adding a set of a partial of additive elements into Au-Ag alloy matrix, heat affected part becomes broader, because Au-Ag alloy is composed with high pure Au and high pure Ag. Consequently, as tail length is apt to have bigger dispersion, a partial of additive elements should be added into Au-Ag alloy matrix inevitably. From aspect of neck strength difference, preferable content of Ag in the Au-Ag alloy matrix is the range of 5 to 25 mass %. At least adding one element from the group of 5 to 50 mass ppm of Ca, 1 to 20 mass ppm of Be, or 5 to 90 mass ppm of rare-earth elements, though it is a partial of content, narrowing effect of heat affected zone is grater than that of pure Au matrix and Au-Pd alloy matrix. Especially Y, La, Ce, Eu and Nd among rare-earth elements have greater effect of narrowing heat affected area. However, if content of these elements is less than lower limit, though content of Ag is in the range of 5 to 25 mass % in Au-Ag alloy matrix, as heat affected part becomes broader, a set of lower limit value is necessary.
By the way, if these elements exceed upper limit, there is narrowing effect of heat affected area, as above-mentioned, from reasons of shape of ball become distorted, upper limit is set. On the other side, group of elements such as Ge, Mg, Sr, Bi, Zn, Si, Ga, Sn, Sb, B or Li has effect of narrowing heat affected area under condition of comparatively much adding.
Moreover, adding exceed of 90 ppm till 0.3 mass %, effect of heat affected part is obtainable, but it does not meet to purity of 99.99 mass % of Au alloy(where except Ag), if content exceed of 90 ppm.
These additives of former and latter include only below 100 ppm in maximum in purity of 99.99 mass % of Au alloy(where except Ag), stable effect which shortening heat affected area is always obtained. It is found that if content of Ag is in the range of 5 to 25 mass % in Au-Ag alloy matrix, satisfactory effect of narrowing heat affected part is obtained in the best way.

Effect of improving anti-Au consumption into solder is accounted hereinafter.
It is known as solder alloy such as principal content of Pb alloy(Pb alloy, Pb-0.3 mass % Sn alloy, Pb-5 mass % Sn alloy, etc.), Pb-free alloy(Sn alloy, Sn-3.5 mass % Ag alloy, Sn-0.8 mass % Cu alloy, Sn-0.5 mass % Ni alloy, Sn-1.0 mass % Zn alloy, Sn-3.5 mass Ag alloy, 0.5 mass % Cu alloy, Sn-20 mass % In alloy, etc.).
It is found that Au-Ag alloy matrix has better effect to improve anti-Au consumption into these solder comparing with pure Au matrix, especially under higher temperature condition. Especially, if content of Ag is in the range of 5 to 25 mass % in Au-Ag alloy matrix under high temperature condition, it improves anti-Au consumption into solder. As additive elements is a partial of content merely affect to anti-Au consumption into solder in Au-Ag alloy matrix, Au-Ag alloy matrix with a set of a partial of additive elements improves anti-Au consumption into solder comparing with pure Au matrix and Au-Pd alloy matrix.

### EMBODIMENT OF THE PRESENT INVENTION

Adding a partial of additives elements(where unit is mass ppm) as same as amount value in the table attached with purity of 99.999 mass % of Au and purity of 99.999 mass % of Ag(where unit is mass %) said embodiment was dissolved in the vacuum furnace and was cast. Drawing this, at 25 µm diameter final heat treatment was processed. After using this ultra fine wire on 100 µm square Al pad in the air by the Sinkawa wire-bonder(UTC-400 type) under condition of 0.5 msec of discharge time balls were formed, in general condition(ball diameter is 62 µm, deformed diameter of ball is 80 µm) ball bonding was performed, all balls were formed within 100 µm square Al pads. The result is shown in the table.

Where "Formability of balls" means that appearance of ball was evaluated by stereo microscope at magnification of 400 X to formed 100 balls, good appearance is shown as "A", small cavity but usable is shown as "B", deformed ball with cavity unusable is shown as "C". Moreover "Ultrasonic bonding ball diameter" is the mean of ball size on Al pad for each 100 balls direction of vertical(Y) and direction of horizontal(X) by Olympas length measurement microscope. Then the difference from mean was introduced by minimum mean square method(shown as "Ultrasonic bonding ball stability X/Y") more than 0.96 value is shown as "A", 0.90 to less than 0.96 value is shown as "B", less than 0.90 is shown as "C". Moreover, "Shear strength" is mean of tensile strength when tensile upward(Z direction) for each 100 wires by the Dage Holdings Shear Strength Tester(PC-2400). Where tail length of bump was measured as "Dispersion of neck height(range)", it is shown as mean. Then smaller than 20 µm of dispersion of neck height(range) is shown as "A", 20 µm to less than 30 µm is shown as "B", bigger than 30 µm is shown as "C". Moreover "Chip damage" is shown as number of cracks around ball on Al pad observing by 400X stereo microscope, no crack is shown as "A", 1 to 4 cracks is shown as "B", more than 5 cracks is shown as "C".

Moreover, "Heat test" was held to 100 Au alloy bumps against Sn-3.5 % Ag alloy, to keep flip-chip structure, was reflowed heated at 250 °C for 60 seconds. Then for each 10 section areas were observed by 400X stereoscope, more than 50 % of before reflow section area is shown as "A", 30 % to less than 50 % is shown as "B", 10 % to less than 30 % is shown as "C", less than 10 % is shown as "D".

At this point, it was found that all of "A", which has more than 50 % of before reflow section area, homogeneously has bump height in solder because tail like whisker at tear off moment melted into Sn-3.5 % Ag alloy. On the other hand, "C", which has less than 10 % of before reflow section area, bump itself melted into Sn-3.5 % Ag alloy and disappear, hence bump bonding was not done.

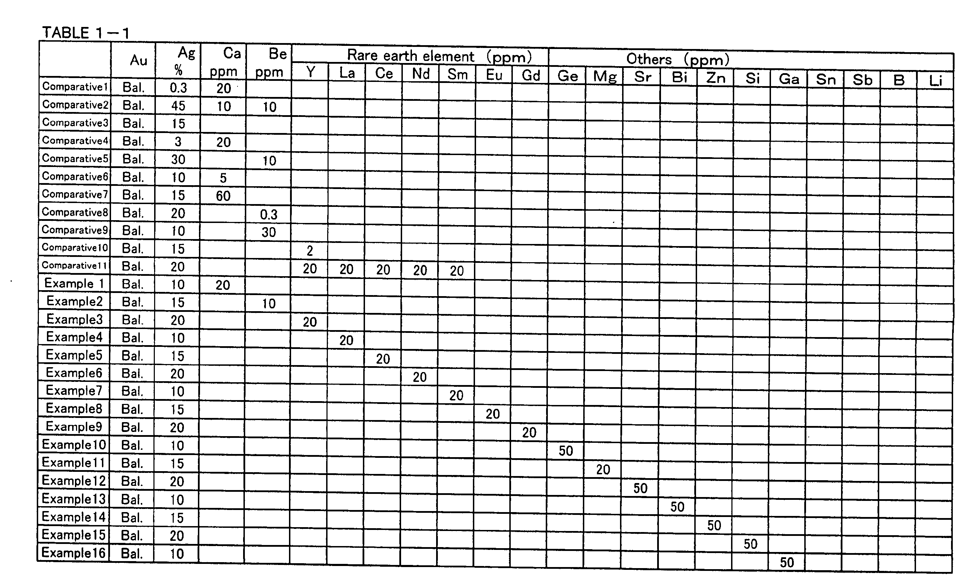

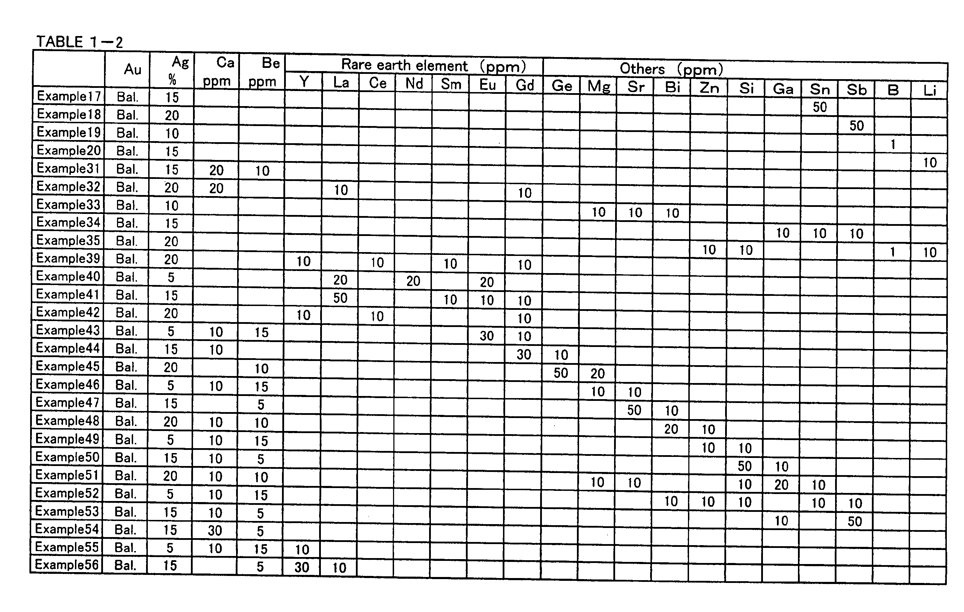

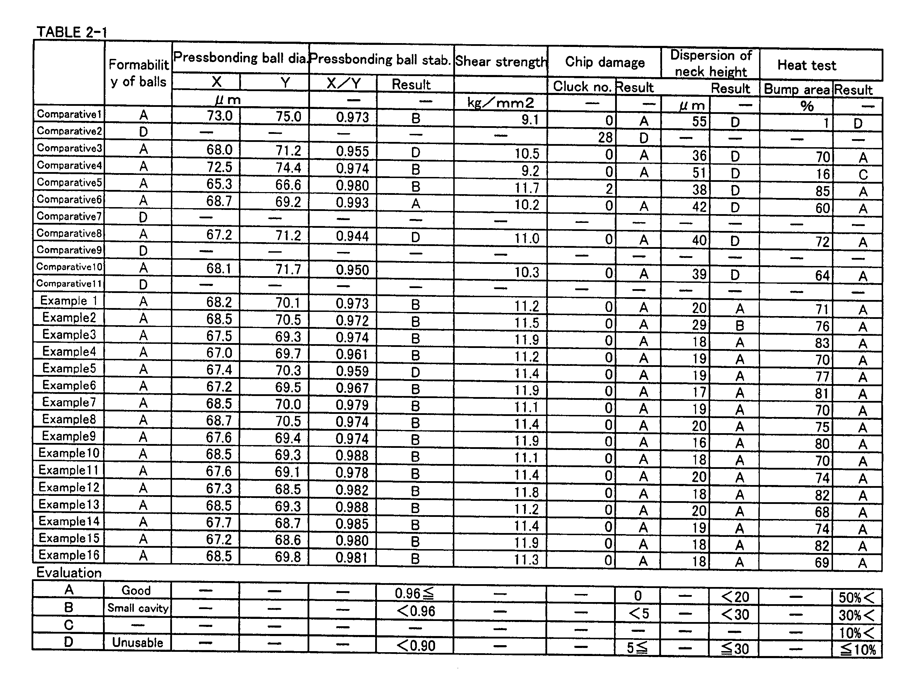

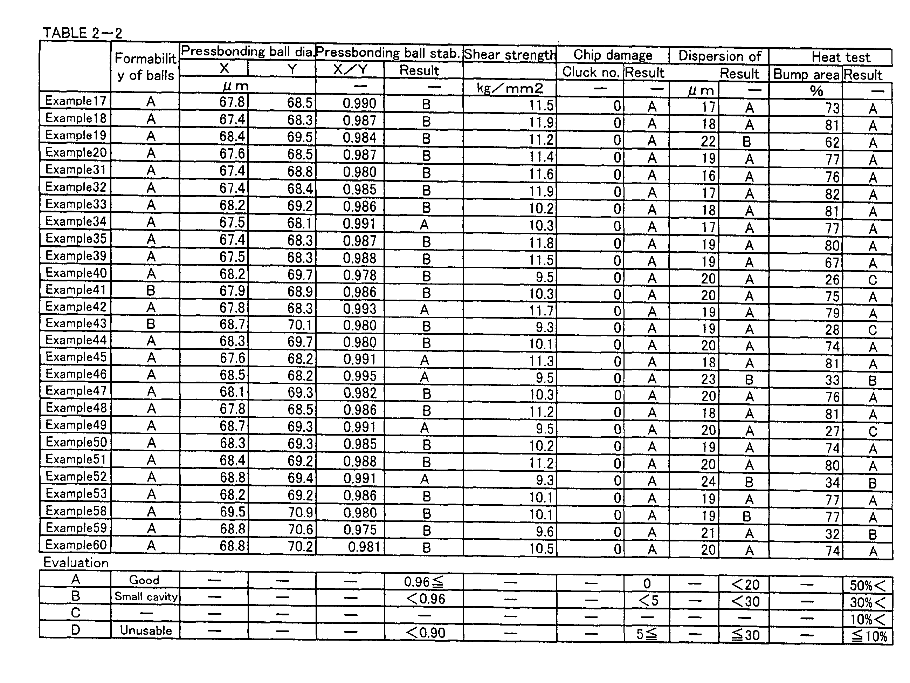

## Claims

1. Wire bumping material comprising the content of:
Au-Ag alloy, which purity of Au is more than 99.99 mass %, comprising Au matrix and a particle of additive elements, consisting of 1 to 40 mass % of Ag, which purity is more than 99.99 mass %.

2. Au-Ag alloy for wire bumping as defined in claim 1, featured wherein said a particle of additive elements, consisting of 5 to 50 mass ppm of Ca, 1 to 20 mass ppm of Be and/or 5 to 90 mass ppm of rare-earth elements.

3. Au-Ag alloy for wire bumping according to claim 1, featured wherein said a particle of additive elements, consisting of 10 to 90 mass ppm of at least one element selected from a group consisting of Ge, Mg, Sr, Bi, Zn, Si, Ga, Sn, Sb, Li, and alloy there of.

4. Au-Ag alloy for wire bumping according to claim 1, featured wherein said a particle of additive elements, consisting of 5 to 50 mass ppm of Ca, 1 to 20 mass ppm of Be and/or 10 to 90 mass ppm of at least one element of rare-earth elements selected from a group consisting of Ge, Mg, Sr, Bi, Zn, Si and Ga, wherein said in the case of single element; B or Li, 0.5 to 40 mass ppm.

5. Au-Ag alloy for wire bumping according to claim 1, 2, 3 and 4, featured wherein said Au matrix consisting of 5 to 25 mass % Ag.

6. Au-Ag alloy for wire bumping according to claim 2 or 4, featured wherein said a particle of additive rare-earth elements, consisting ofY, La, Ce, Eu, Nd, Gd, Sm, and alloy there of.

7. Au-Ag alloy for wire bumping according to claim 1 to 6, featured wherein said bonding to Pb matrix solder or Sn matrix solder.

8. Au-Ag alloy for wire bumping according to claim 1 to 6, featured wherein said flip chip bonding to Pb-free Sn matrix solder.

9. Au-Ag alloy for wire bumping according to claim 1 to 6, featured wherein said flip chip bonding to Pb-free Sn matrix solder, which has 170 °C to 260 °C melting point.
